(19) **Europäisches Patentamt · European Patent Office · Office européen des brevets**

(11) **EP 1 465 335 B1**

(12) **EUROPÄISCHE PATENTSCHRIFT**

(45) Veröffentlichungstag und Bekanntmachung des Hinweises auf die Patenterteilung:
**15.08.2007 Patentblatt 2007/33**

(51) Int Cl.:
***H03F 3/08*** *(2006.01)*

(21) Anmeldenummer: **03405218.3**

(22) Anmeldetag: **01.04.2003**

(54) **Rauscharmer Lichtempfänger**

Low noise light receiver

Récepteur optique à bruit faible

(84) Benannte Vertragsstaaten:
**CH DE FR GB IT LI**

(43) Veröffentlichungstag der Anmeldung:
**06.10.2004 Patentblatt 2004/41**

(73) Patentinhaber: **Optosys SA**
**1762 Givisiez (CH)**

(72) Erfinder: **Heimlicher, Peter**
**1700 Fribourg (CH)**

(74) Vertreter: **AMMANN PATENTANWÄLTE AG BERN**
**Schwarztorstrasse 31**
**3001 Bern (CH)**

(56) Entgegenhaltungen:
| | |
|---|---|
| **EP-A- 0 100 387** | **EP-A- 0 494 420** |
| **EP-A- 1 065 809** | **US-A- 5 714 909** |
| **US-A- 5 734 300** | **US-A- 6 084 232** |
| **US-B1- 6 329 881** | |

**Beschreibung**

Die Erfindung bezieht sich auf einen rauscharmen Lichtempfänger gemäss Oberbegriff des Anspruchs 1.

Bei der Umwandlung von Licht in elektrischen Strom zum Zweck der Signalübertragung sind sowohl die Anforderungen wie auch die Realisierungsmöglichkeiten vielfältig. Praktisch immer soll dabei die Umwandlung bei gegebener Signalbandbreite und Empfangslichtstärke möglichst rauscharm erfolgen.

Ein sehr häufig eingesetztes Element zur Umwandlung von Lichtsignalen in elektrische Signale ist die Photodiode. Sie ist anderen Wandlern in vielen Fällen überlegen. Da das von einer Photodiode abgegebene elektrische Signal normalerweise sehr schwach ist, muss es mit Hilfe eines Verstärkers verstärkt werden, bevor es genutzt werden kann. Photodiode und Verstärker bestimmen bei gegebener Bandbreite und Empfangslichtstärke weitgehend das Signal-Rausch-Verhältnis, welches das am Ausgang des Verstärkers zur Verfügung stehende Signal aufweist. Als Literatur zum entsprechenden Stand der Technik sei beispielsweise das Buch "Photodiode Amplifiers" von Jerald G. Graeme, McGraw-Hill, New York, 1996 genannt.

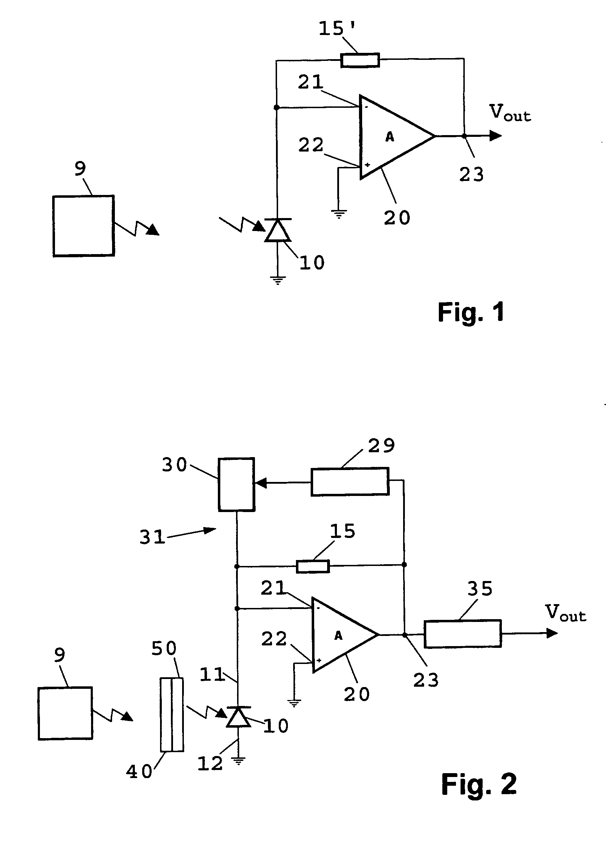

Fig. 1 zeigt eine üblicherweise eingesetzte Anordnung von Photodiode 10 und Verstärker 20. Die Photodiode 10 ist an den invertierenden Eingang 21 des Verstärkers 20 angeschlossen und über einen Arbeitswiderstand 15' mit dem Ausgang 23 des Verstärkers 20 verbunden. Die am Ausgang 23 gemessene Spannung $V_{out}$ ist im Wesentlichen proportional zum Strom, welchen die Photodiode 10 beim Empfangen der von einer Lichtquelle 9 ausgesendeten Lichtsignale erzeugt. Die Anordnung gemäss Fig. 1 wirkt demnach als Strom/Spannungs-Konverter.

Die wesentlichen Rauschquellen der Anordnung gemäss Fig. 1 sind die Photodiode 10 und der Arbeitswiderstand 15'. Das Rauschen des Verstärkers 20 hingegen ist bei starkem Umgebungslicht, wie es bei Sensorik-Anwendungen vorhanden sein kann, vernachlässigbar. Der Arbeitswiderstand 15' erzeugt aufgrund von thermischen Rauschen einen Rauschstrom, welcher den Hauptteil des Gesamtrauschens ausmacht. Ein grundsätzlicher Nachteil der Anordnung gemäss Fig. 1 besteht nun darin, dass der Arbeitswiderstand 15' so dimensioniert sein muss, dass auch dann keine Sättigung des Verstärkers 20 auftritt, wenn ein starkes Umgebungslicht (in der Mittagssonne z.B. ca. 100'000 Lux) dem Lichtsignal der Lichtquelle 9 überlagert ist. Eine Sättigung des Verstärkers 20 wird durch Wahl eines relativ kleinen Arbeitswiderstandes 15' verhindert. Bei einer Photodiode mit einer Chipfläche von 1 mm² beispielsweise liegt dieser bei ca. $R_f$ = 22 kOhm. Ein kleiner Widerstand $R_f$ führt jedoch zwangsläufig zu einem relativ hohen Wert für den durch den Widerstand 15' erzeugten thermischen Rauschstrom. Dies ist aus der Formel 1 ersichtlich, gemäss welcher

$$i_{nt} = \sqrt{\frac{4kT\Delta f}{R_f}} \qquad\qquad \textbf{(Formel 1)}$$

wobei

$i_{nt}$ = thermischer Rauschstrom [A]
$k$ = Boltzmann-Konstante, $1.38 \times 10^{-23}$ JK$^{-1}$
$T$ = Temperatur in Kelvin [K]
$\Delta f$ = Rauschbandbreite [Hertz]
$R_f$ = Arbeitswiderstand [Ohm]

Ein übermässiges Rauschen des Lichtempfängers ist jedoch nachteilig, da dadurch ein entsprechend schlechtes Signal-Rausch-Verhältnis resultiert.

In der Patentschrift US-5,714,909 ist ein Lichtempfänger mit einem Transimpedanz-Verstärker zur Verarbeitung eines von einer Photodiode erzeugten Stromsignals beschrieben. Der Verstärker umfasst eine Rückkopplungsschleife zur Erzeugung eines Rückführungssignal, welches das vom Umgebungslicht erzeugte Stromsignal aufhebt. Dieser Lichtempfänger hat den Nachteil, dass bei starkem Umgebungslicht die Photodiode aufgrund des hohen Photostroms ein übermässiges Schrotrauschen erzeugt, welches zu einer Verschlechterung des Signal-Rausch-Verhältnisses führt.

Aus der japanischen Patentanmeldung JP-A-07-208918 ist es bekannt, zur Verbesserung des Signal-Rausch-Verhältnisses ein optisches Filter zu verwenden, welches lediglich Licht durchlässt, das in einem bestimmten Einfallswinkel auftrifft.

Aus der Patentschrift US-6,329,881 B1 ist ein Lichtempfänger mit einem Vorverstärker bekannt, welcher eine Stromrückkopplungsschaltung, eine Schaltung zum Erfassen der mittleren Ausgangsspannung der Stromrückkopplungsschaltung und eine Stromregelungsschaltung zum Verändern des optischen Eingangsstroms in Abhängigkeit von der erfassten mittleren Ausgangsspannung umfasst. Auch dieser Lichtempfänger hat den Nachteil, dass bei starkem Umgebungslicht ein übermässiges Schrotrauschen erzeugt wird, welches zu einer Verschlechterung des Signal-Rausch-Verhältnisses führt.

Ausgehend von diesem Stand der Technik ist es Aufgabe der vorliegenden Erfindung, einen Lichtempfänger zu schaffen, welcher auch bei starkem Umgebungslicht funktionsfähig bleibt, jedoch ein besseres Signal-Rausch-Verhältnis aufweist.

Ein Lichtempfänger, der diese Aufgabe löst, ist im Anspruch 1 angegeben. Die weiteren Ansprüche geben bevorzugte Ausführungen an.

Der Lichtempfänger gemäss Anspruch 1 hat den Vorteil, dass er auch bei starkem Umgebungslicht einsetzbar ist, jedoch aufgrund seines geringeren Rauschens ein besseres Signal-Rausch-Verhältnis aufweist.

Die Erfindung wird im Folgenden anhand eines bevorzugten Ausführungsbeispiels unter Bezugnahme auf Figuren erläutert. Es zeigen

Fig. 1    einen bekannten Lichtempfänger;
Fig. 2    einen erfindungsgemässen Lichtempfänger;
Fig. 3    die Transmissionskurve 51 eines Farbfilters, die spektrale Empfindlichkeit 60 einer typischen Silizium-Photodiode sowie die spektrale Energieverteilung 70 des Sonnenlichts;
Fig. 4    die Transmissionskurve 41 eines dielektrischen optischen Filters sowie die beiden Kurven 60 und 70 gemäss Fig. 2;
Fig. 5    eine Überlagerung der Figuren 3 und 4; und
Fig. 6    die spektrale Empfindlichkeit 61 von verschiedenen wellenlängenselektiven Photodioden, die Kurve 60 gemäss Fig. 3 sowie die theoretisch erzielbare Grenze 63 der spektralen Empfindlichkeit.

Der in Fig. 2 gezeigte Lichtempfänger umfasst einen Lichtsensor, der beispielsweise eine Photodiode 10 üblicher Art ist, sowie einen Verstärker 20 beispielsweise in Form eines Operationsverstärkers. Die Kathode 11 der Photodiode 10 ist an dem invertierenden Eingang 21 des Verstärkers 20 angeschlossen, die Anode 12 der Photodiode 10 sowie der nicht-invertierende Eingang 22 des Verstärkers 20 sind an Masse gelegt. Die Photodiode 10 gemäss Fig. 2 ist somit im photovoltaischen Modus betrieben, d.h. es ist keine äussere Spannung an die Photodiode 10 angelegt. Es ist jedoch auch denkbar, die Photodiode 10 in Sperrrichtung zu betreiben (photoleitender Modus).

Der Ausgang 23 des Verstärkers 20 ist mit einem Widerstand 15 verbunden, der wiederum am invertierenden Eingang 21 des Verstärkers 20 angeschlossen ist, sodass dadurch das Ausgangssignal des Verstärkers 20 rückgekoppelt werden kann.

Wie Fig. 2 weiter zeigt, sind zusätzlich elektrische Filtermittel 29 und 30 vorgesehen, die parallel zum Widerstand 15 angeschlossen sind. Die Filtermittel 29 und 30 sind dazu mit dem Ausgang 23 des Verstärkers 20 und mit seinem invertierenden Eingang 21 verbunden, sodass ein Gegenkopplungspfad 31 gebildet ist. Sie umfassen ein Tiefpassfilter 29 und eine damit verbundene Stromsenke 30 z.B. in Form einer stromgesteuerten oder spannungsgesteuerten Stromquelle. Die Stromsenke 30 bildet das Stellglied einer Regelstrecke, wobei die Regelung in der Anordnung gemäss Fig. 2 durch die Gegenkopplung erzielt wird. Stromsenke 30 sowie Tiefpassfilter 29 sind dem Fachmann bekannt und werden daher nicht eingehender beschrieben.

Beim Empfangen von Lichtsignalen einer Nutzlichtquelle 9 wie einer Leuchtdiode erzeugt die Photodiode 10 einen Photostrom als Nutzsignal. Die Lichtsignale werden dabei in Form von Lichtimpulsen in einer bestimmten Pulsfrequenz Fp ausgesendet, sodass das Nutzsignal ebenfalls die Frequenz Fp aufweist.

Ist nun eine Störlichtquelle wie natürliches oder künstliches Umgebungslicht vorhanden, so erzeugt die Photodiode 10 einen zusätzlichen, unerwünschten Photostrom als Störsignal, welches dem Nutzsignal überlagert ist.

Die Frequenz Fp ist so gewählt, dass der Frequenzbereich des Umgebungslicht wesentlich tiefer ist. Typischerweise ist Fp = 15 kHz. Übliche Lampen z.B. weisen hingegen eine Modulationsfrequenz von 100 Hz auf. Diese Erkenntnis erlaubt es, den durch die Photodiode 10 erzeugten Photostrom in eine dem Nutzsignal entsprechende und in eine dem Störsignal entsprechende Komponente aufzuteilen und diese beiden Komponenten getrennt zu verarbeiten. Dazu sind die elektrischen Filtermittel 29 und 30 des Lichtempfängers entsprechend der Frequenz Fp ausgelegt. Die Grenzfrequenz des Tiefpassfilters 29 ist dabei kleiner als die Frequenz Fp gewählt, so dass das Nutzsignal nur vernachlässigbar gegengekoppelt wird und demnach der Stromsenke 30 im Wesentlichen das Störsignal zugeführt wird. Die Stromsenke 30 ihrerseits wird durch die Gegenkopplung so geregelt, dass sie einen Strom als Korrektursignal erzeugt, welche das zugeführte Störsignal im Wesentlichen kompensiert.

Der Gegenkopplungspfad 31 wirkt demnach wie eine Frequenzweiche, die Stör- und Nutzsignal trennt. Da nun durch den Widerstand 15 im Wesentlichen der Anteil des Photostroms fliesst, der dem Nutzsignal entspricht, braucht dieser lediglich für die maximal zu verarbeitende Nutzsignalamplitude ausgelegt werden. Dies ist im Gegensatz zur Anordnung gemäss Fig. 1, bei welcher der Widerstand 15' für die Summe von Störsignal und Nutzsignal auszulegen ist, um einer Sättigung des Verstärkers vorzubeugen. Für den Widerstand 15 kann deshalb ein wesentlich höherer Wert gewählt werden (typischerweise ca. $R_f$ = 1 MOhm), sodass er gemäss der Formel 1 ein entsprechend geringeres Rauschen erzeugt.

Zwar stellen die Filtermittel 29, 30 zusätzliche, unerwünschte Rauschquellen dar, jedoch verglichen mit der Reduktion, die durch den Einsatz eines höherohmigen Widerstandes 15 erzielbar ist, ist das zusätzliche Rauschen vernachlässigbar. Der dominierende Anteil des von der Stromsenke 30 erzeugten Rauschens ist Schrotrauschen (unregelmässige Stromschwankungen, die dadurch entstehen, dass der Ladungstransport durch die Bewegung diskreter Ladungsträger zustande kommt). Wie weiter unten zur Formel 2 genauer erläutert wird, ist das Schrotrauschen im Wesentlichen proportional zur Wurzel des fliessenden Stroms. Da der durch die Stromsenke 30 erzeugte Strom im Wesentlichen gleich dem Photostrom ist, ergibt sich eine Erhöhung des Gesamtrauschens um lediglich $2^{1/2} \approx 1.41$. Gemäss obigem Beispiel ist hingegen die Reduktion des Rauschens durch den Einsatz eines höherohmigen Widerstandes wesentlich grösser: $(1\ \mathrm{MOhm}/22\ \mathrm{kOhm})^{1/2} \approx 6.75$. Das Rauschen des Tiefpassfilters 29 ist vernachlässigbar, da es in einem tiefen und daher nicht relevanten Frequenzbereich liegt.

Der Einsatz der Filtermittel 29 und 30 gemäss Fig. 2 ermöglicht es, das Nutz- und Störsignal zu trennen, sodass mit den Signalverarbeitungsmitteln 15, 20 lediglich im Wesentlichen das Nutzsignal verarbeitet werden kann, währenddem das Störsignal in die Stromsenke 30 abgeleitet wird. Dadurch kann das Rauschen des Lichtempfängers gesenkt werden, wobei gleichzeitig einer Sättigung des Verstärkers 20 durch Umgebungslicht vorgebeugt wird.

Optional umfasst der in Fig. 2 gezeigte Lichtempfänger weiter ein elektrisches Bandpassfilter 35 bekannter Art, welches in Serie mit dem Ausgang des Verstärkers angeschlossen ist. Das Bandpassfilter 35 ist so ausgelegt, dass es das Nutzsignal weitgehend unbeeinflusst passieren lässt, während die nicht gewünschten Komponenten des Spektrums rauschvermindernd herausgefiltert werden. Dadurch kann das Signal-Rausch-Verhältnis weiter verbessert werden.

Bei starkem Umgebungslicht kann die Photodiode 10 einen so hohen Photostrom erzeugen, dass ein unter Umständen nicht mehr vernachlässigbares Schrotrauschen entsteht. Das Schrotrauschen ist gegeben durch

$$i_{ns} = \sqrt{2q(I_d + I_{ph})\Delta f} \qquad \text{(Formel 2)}$$

wobei

$i_{ns}$ = Schrot-Rauschstrom [A]
$q$ = Elektronenladung, $1.6 \times 10^{-19}$ Coulomb
$I_d$ = Dunkelstrom [A]
$I_{ph}$ = Photostrom [A]
$\Delta f$ = Rauschbandbreite [Hertz]

Zur Unterdrückung vor allem dieses Schrotrauschens sind daher als weitere Option optische Filtermittel 40 und 50 vorgesehen, mit welchen das auf die Photodiode 10 einfallende Umgebungslicht reduziert werden kann. Die optischen Filtermittel 40 und 50 sind entsprechend der Wellenlänge $\lambda_0$ des von der Leuchtdiode 9 ausgesendeten Lichtsignals (z.B. $\lambda_0 = 0.680\ \mu\mathrm{m}$) ausgelegt und umfassen ein erstes Filter 40 sowie vorzugsweise ein zweites Filter 50.

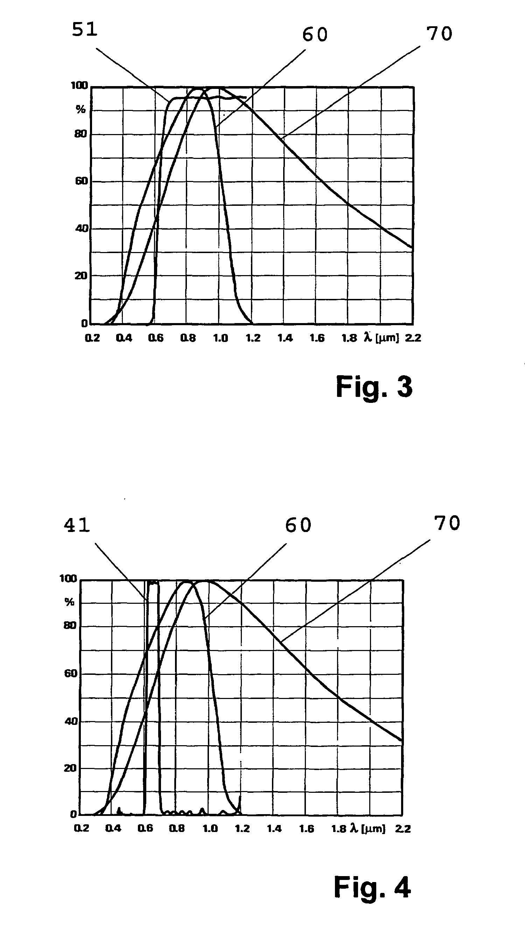

Das erste Filter 40 ist ein dielektrisches Bandpassfilter (Interferenzfilter mit einer bestimmten Anzahl von dünnen, dielektrischen Schichten). Kurve 41 in Fig. 4 zeigt das Durchlassverhalten eines geeigneten Bandpassfilters 40 in Abhängigkeit der Wellenlänge $\lambda$ des einfallenden Lichts (Transmissionskurve). Der Durchlassbereich ist auf die Wellenlänge $\lambda_0$ der Nutzlichtquelle 9 abgestimmt und relativ schmal, wobei die Flanken der Kurve 41 vorteilhafterweise steil sind.

Die Charakteristik des Bandpassfilters 40 ist für einen bestimmten Wellenlängenbereich spezifiziert ("Nahbereich"). Die untere und obere Grenze dieses Wellenlängenbereichs werden im Folgenden mit $\lambda_1$ bzw. $\lambda_2$ bezeichnet. Die Breite des Wellenlängenbereichs $\lambda_2$-$\lambda_1$ ist unter anderem durch die Anzahl der verwendeten optischen Schichten gegeben. Beim Bandpassfilter 40 mit der in Fig. 4 gezeigten Transmissionskurve 41 werden ca. sechzig optische Schichten verwendet, so dass $\lambda_1$ bei etwa $0.4\ \mu\mathrm{m}$ und $\lambda_2$ bei etwa $1.2\ \mu\mathrm{m}$ zu liegen kommen.

Ausserhalb des spezifizierten Wellenlängenbereichs ($\lambda < \lambda_1$ bzw. $\lambda > \lambda_2$, "Fernbereich") zeigt ein dielektrisches Bandpassfilter jedoch ein schlechtes Sperrverhalten. Die Herstellung eines Bandpassfilters mit einem sehr breiten Wellenlängenbereich ist aufgrund der grossen Anzahl der nötigen optischen Schichten aufwendig und teuer.

Um ein gutes Sperrverhalten für Wellenlängen kleiner als $\lambda_1$ zu garantieren, ist zusätzlich ein zweites Filter 50 nach dem Bandpassfilter 40 angeordnet. Das zweite Filter 50 ist ein Farbfilter und ist z.B. durch Einfärbung von Kunststoff oder Glas hergestellt. Kurve 51 in Fig. 3 zeigt das Durchlassverhalten eines geeigneten Farbfilters 50. Dieses absorbiert Licht mit einer Wellenlänge von weniger als $\lambda_0$ und insbesondere weniger als $\lambda_1$ währenddessen es für Licht mit einer Wellenlänge von mehr als $\lambda_0$ nahezu durchlässig ist. Es wirkt demnach wie ein Kantenfilter.

Da die üblichen Photodioden für grosse Wellenlängen kaum empfindlich sind, fällt ein schlechtes Sperrverhalten des Bandpassfilters 40 für den Bereichs $\lambda > \lambda_2$ kaum ins Gewicht. Fig. 4 zeigt die spektrale Empfindlichkeit 60 einer typischen Photodiode aus Silizium (normiert mit dem Maximalwert). Die Empfindlichkeit ist für Wellenlängen grösser als $\lambda_2$ nahezu Null. Es ist jedoch denkbar, weitere Farbfilter zu verwenden, um das Sperrverhalten des Bandpassfilters 40 bei grösseren Wellenlängen zu verbessern. Zum Vergleich ist in Fig. 4 ebenfalls die spektrale Energieverteilung 70 des Sonnenlichts (normiert mit dem Maximalwert) gezeigt.

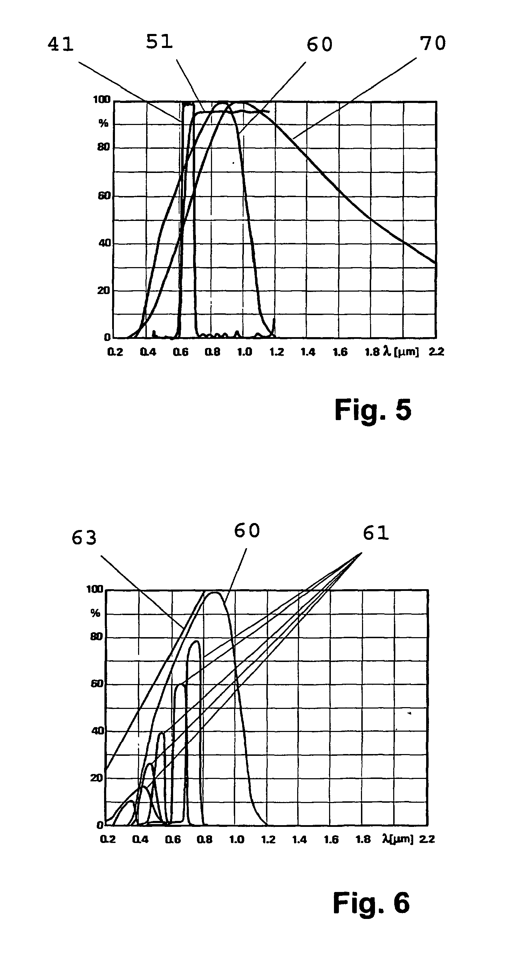

Durch hintereinanderliegende Anordnung eines dielektrischen Bandpassfilters 40 mit einer Charakteristik gemäss Kurve 41 und eines Farbfilters 50 mit einer Charakteristik gemäss Kurve 51, resultiert ein schmalbandiges optisches Filter mit sehr steilen Flanken und mit gleichzeitig sehr guten Sperreigenschaften im Fernbereich. Wie Fig. 5 zeigt, liegt die Flanke des Farbfilters am kurzwelligen Ende des Durchlassbereichs des Bandpassfilters 41. Durch Verwendung der optischen Filtermittel 40 und 50 kann ein grosser Teil des Umgebungslichts, welches im empfindlichen Bereich der Photodiode 10 liegt, wirksam herausgefiltert werden und so insbesondere das Schrotrauschen der Photodiode 10 stark reduziert werden.

Eine zusätzliche optische Filterung kann durch die Verwendung wellenlängenselektiver Photodioden erzielt werden. Diese sind lediglich in einem engen Wellenlängenbereich um $\lambda_0$ empfindlich. Fig. 6 zeigt die Durchlasskurven 61 von sechs verschiedenen solchen wellenlängenselektiven Photodioden. Die Filterwirkung wird durch Wahl und Dotierung des Halbleitermaterials der Photodiode festgelegt. Zum Vergleich sind die Empfindlichkeitskurve 60 einer Silizium-Photodiode gemäss Fig. 3 sowie die theoretisch mögliche Grenzlinie 63 gezeigt.

Die Anwendung der hier beschriebenen elektrischen und optischen Filtermittel führt zu einer wesentlichen Reduktion des Rauschens auch bei breitbandigem, starkem Umgebungslicht. Je nach Art und Intensität des Umgebungslichts kann eine Verbesserung des Signal-Rausch-Verhältnisses erzielt werden, welche im Bereich von 15 bis 20 dB liegt. Dadurch kann eine höhere Reichweite zwischen Lichtempfänger und Nutzlichtquelle und/oder eine grössere Bandbreite des Nutzsignals erreicht werden.

Lichtempfänger werden u.a. bei photoelektrischen Näherungsschaltern verwendet, die z.B. im Fertigungs-, Förder- sowie Lagerbereich als Sensor zur Feststellung eines in einem Überwachungsbereich vorhandenen Gegenstandes zur Anwendung kommen. Durch Einsatz des hier beschriebenen Lichtempfängers kann die Leistungsfähigkeit eines solchen Näherungsschalters wesentlich erhöht werden.

Aus der vorangehenden Beschreibung sind dem Fachmann zahlreiche Abwandlungen zugänglich, ohne den Schutzbereich der Erfindung zu verlassen, der durch die Ansprüche definiert ist.

Die hier beschriebenen Massnahmen zur Verminderung des Rauschens hängen primär nicht von der Art und der Betriebsweise des verwendeten Lichtsensors ab. So ist z.B. eine wesentliche Rauschverminderung auch für eine Photodiode 10 erzielbar, die mit einer Vorspannung in Sperrrichtung betrieben wird (photoleitender Modus).

Weiter ist es denkbar, anstelle des Tiefpassfilters ein elektrisches Bandsperrfilter zum Herausfiltern des Nutzsignals im Gegenkopplungspfad zu verwenden. Allerdings sind dann weitere elektrische Elemente nötig, um ein stabile Gegenkopplung zu erzielen. Im Weiteren ist auch die Verwendung digitaler Filter möglich.

**Patentansprüche**

1.  Rauscharmer Lichtempfänger mit

    einem Lichtsensor (10), insbesondere Photodiode, mit welchem ein Sensorsignal erzeugbar ist, das ein von einer Nutzlichtquelle (9) herrührendes Nutzsignal und ein Störsignal umfasst, mit
    Verarbeitungsmitteln (15, 20), die mit dem Lichtsensor in Wirkverbindung stehen, zur Verarbeitung des Sensorsignals, sodass ein Ausgangssignal ($V_{out}$) erzeugbar ist, und mit
    elektrischen Filtermitteln (29, 30) zum Herausfiltern des Störsignals, welche mit dem Lichtsensor in Wirkverbindung stehen und mit welchen ein Korrektursignal erzeugbar ist, welches das Störsignal im Wesentlichen kompensiert, sodass mit den Verarbeitungsmitteln im Wesentlichen das Nutzsignal verarbeitbar ist,
    wobei die Verarbeitungsmittel (15, 20) einen Verstärker (20) mit einem Rückkopplungswiderstand (15) und die elektrischen Filtermittel (29, 30) ein Tiefpassfilter (29) zum Herausfiltern des Störsignals und eine Stromsenke (30) zum Erzeugen des Korrektursignals umfassen, **dadurch gekennzeichnet, dass**
    der Widerstandswert des Rückkopplungswiderstandes (15) zur Reduktion seines thermischen Rauschens so gross gewählt ist, dass bei der Verarbeitung des Sensorsignals eine Sättigung des Verstärkers (20) noch vermieden ist, und
    dass der Lichtempfänger zur Reduktion des vom Lichtsensor (10) erzeugten Schrotrauschens ein dielektrisches Bandpassfilter (40) umfasst, mittels welchem auf den Lichtsensor einfallendes Licht reduzierbar ist, das im empfindlichen Wellenlängenbereich des Lichtsensors liegt.

2.  Lichtempfänger nach Anspruch 1, **dadurch gekennzeichnet, dass** die Stromsenke (30) regelbar ist, sodass das Störsignal im Wesentlichen kompensiert werden kann.

**3.** Lichtempfänger nach Anspruch 1 oder 2, **dadurch gekennzeichnet, dass** er für eine Nutzlichtquelle (9) ausgelegt ist, mit welcher Lichtimpulse erzeugbar sind, wobei der Durchlassbereich des dielektrischen Bandpassfilters (40) auf die Wellenlänge ($\lambda_0$) des Lichts der Lichtimpulse abgestimmt ist.

**4.** Lichtempfänger nach Anspruch 3, **dadurch gekennzeichnet, dass** die Grenzfrequenz des Tiefpassfilters (29) kleiner als die Pulsfrequenz Fp ist, mit welcher die Lichtimpulse erzeugt werden.

**5.** Lichtempfänger nach einem der Ansprüche 1 bis 4, **dadurch gekennzeichnet, dass** die elektrischen Filtermittel (29, 30) parallel mit den Verarbeitungsmitteln (15, 20) verbunden sind.

**6.** Lichtempfänger nach einem der Ansprüche 1 bis 5, **dadurch gekennzeichnet, dass** das dielektrische Bandpassfilter (40) schmalbandig ist.

**7.** Lichtempfänger nach einem der Ansprüche 1 bis 6, **dadurch gekennzeichnet, dass** er mindestens ein optisches Kantenfilter (50), insbesondere Farbfilter aufweist.

**8.** Lichtempfänger nach Anspruch 7, **dadurch gekennzeichnet, dass** die Flanke des Kantenfilters (50) am kurzwelligen Ende des Durchlassbereichs des Bandpassfilters (40) liegt.

**9.** Lichtempfänger nach einem der Ansprüche 1 bis 8, **dadurch gekennzeichnet, dass** der Lichtsensor eine Photodiode ist, die vorzugsweise wellenlängenselektiv ist.

**10.** Anwendung eines Lichtempfänger nach einem der Ansprüche 1 bis 9 in einem photoelektrischen Näherungsschalter.

**Claims**

**1.** Low noise light receiver, comprising

a light sensor (10), more particularly a photodiode, for generating a sensor signal comprising a wanted signal resulting from an effective light source (9) and an interfering signal,
processing means (15, 20) that are operatively connected to the light sensor, for processing the sensor signal such that an output signal ($V_{out}$) can be generated, and
electric filter means (29, 30) for filtering out the interfering signal, which are operatively connected to the light sensor and allow to generate a correction signal that essentially compensates the interfering signal such that the processing means may essentially process the wanted signal,
the processing means (15, 20) comprising an amplifier (20) with a feedback resistor (15)
and the electric filter means (29, 30) comprising a low pass filter (29) for filtering out the interfering signal and a current sink (30) for generating the correction signal, **characterised in that**
in order to reduce its thermal noise, the resistor value of the feedback resistor (15) is chosen high enough to still avoid a saturation of the amplifier (20) while the sensor signal is being processed, and
**in that** in order to reduce the shot noise produced by the light sensor (10), the light receiver comprises a dielectric band pass filter (40) that allows reducing light impinging on the light sensor that lies within the sensitive wavelength range of the light sensor.

**2.** Light receiver according to claim 1, **characterised in that** the current sink (30) is capable of being regulated in such a manner that the interfering signal can essentially be compensated.

**3.** Light receiver according to claim 1 or 2, **characterised in that** it is designed for an effective light source (9) that is capable of producing light pulses, the transmission range of the dielectric band pass filter (40) being adjusted to the wavelength ($\lambda_0$) of the light of the light pulses.

**4.** Light receiver according to claim 3, **characterised in that** the cutoff frequency of the low pass filter (29) is lower than the pulse frequency Fp at which the light pulses are produced.

**5.** Light receiver according to one of claims 1 to 4, **characterised in that** the electric filter means (29, 30) are connected in parallel to the processing means (15, 20).

6. Light receiver according to one of claims 1 to 5, **characterised in that** the dielectric band pass filter (40) is narrow-banded.

7. Light receiver according to one of claims 1 to 6, **characterised in that** it includes at least one optical edge filter (50), more particularly a colour filter.

8. Light receiver according to claim 7, **characterised in that** the edge of the edge filter (50) is located at the short-wave end of the transmission range of the band pass filter (40).

9. Light receiver according to one of claims 1 to 8, **characterised in that** the light sensor is a photodiode, preferably a wavelength-selective one.

10. Application of a light receiver according to one of claims 1 to 9 in a photoelectric proximity switch.


**Revendications**

1. Récepteur optique à faible bruit, comprenant

   un capteur de lumière (10), plus particulièrement une photodiode, capable de générer un signal de capteur qui comprend un signal utile engendré par une source (9) de lumière utile et un signal perturbateur,
   des moyens de traitement (15, 20) fonctionnellement reliés au capteur de lumière, pour traiter le signal de capteur de telle manière qu'un signal de sortie ($V_{out}$) peut être généré, et
   des moyens de filtrage électriques (29, 30) pour éliminer le signal perturbateur, lesquels sont fonctionnellement reliés au capteur de lumière et permettent de générer un signal de correction qui compense essentiellement le signal perturbateur, de telle manière que lesdits moyens de traitement peuvent essentiellement traiter le signal utile,
   lesdits moyens de traitement (15, 20) comprenant un amplificateur (20) avec une résistance de contre-réaction (15)
   et les moyens de filtrage électriques (29, 30) comprenant un filtre passe-bas (29) pour éliminer le signal perturbateur et un récepteur de courant (30) pour générer le signal de correction, **caractérisé en ce que**
   pour réduire son bruit thermique, la valeur de résistance de la résistance de contre-réaction (15) est choisie si grande qu'une saturation de l'amplificateur (20) pendant le traitement du signal de capteur est encore évitée, et que le récepteur optique comporte, pour réduire le bruit de grenaille produit par le capteur de lumière (10), un filtre passe-bande (40) diélectrique qui permet de réduire la lumière incidente sur le capteur de lumière qui est située dans la plage sensible de longueurs d'onde du capteur de lumière.

2. Récepteur optique selon la revendication 1, **caractérisé en ce que** le récepteur de courant (30) est réglable de telle manière que le signal perturbateur peut être essentiellement compensé.

3. Récepteur optique selon la revendication 1 ou 2, **caractérisé en ce qu'**il est conçu pour une source (9) de lumière utile permettant de produire des impulsions lumineuses, la plage de transmission du filtre passe-bande diélectrique (40) étant adaptée à la longueur d'onde ($\lambda_0$) de la lumière des impulsions lumineuses.

4. Récepteur optique selon la revendication 3, **caractérisé en ce que** la fréquence de coupure du filtre passe-bas (29) est inférieure à la fréquence d'impulsion Fp à laquelle les impulsions lumineuses sont produites.

5. Récepteur optique selon l'une des revendications 1 à 4, **caractérisé en ce que** les moyens de filtrage électriques (29, 30) sont connectés en parallèle aux moyens de traitement (15, 20).

6. Récepteur optique selon l'une des revendications 1 à 5, **caractérisé en ce** le filtre passe-bande diélectrique (40) est un filtre à bande étroite.

7. Récepteur optique selon l'une des revendications 1 à 6, **caractérisé en ce qu'**il comprend au moins un filtre optique de coupure (50), plus particulièrement un filtre coloré.

8. Récepteur optique selon la revendication 7, **caractérisé en ce que** le flanc du filtre de coupure (50) se trouve à l'extrémité d'onde courte de la plage de transmission du filtre passe-bande (40).

9. Récepteur optique selon l'une des revendications 1 à 8, **caractérisé en ce que** le capteur de lumière est une photodiode laquelle est préférablement sélective en longueur d'onde.

10. Utilisation d'un récepteur optique selon l'une des revendications 1 à 9 dans un commutateur de proximité photoé-lectrique.

15'

21

22

$V_{out}$

23

A

20

9

10

**Fig. 1**

29

30

31

15

21

22

35

A

$V_{out}$

9

50

11

10

20

23

40

12

**Fig. 2**

**Fig. 3**

**Fig. 4**

**Fig. 5**

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5714909 A
- JP 7208918 A
- US 6329881 B1

**In der Beschreibung aufgeführte Nicht-Patentliteratur**

- **JERALD G. GRAEME.** Photodiode Amplifiers. Mc-Graw-Hill, 1996